# EUROPÄISCHE PATENTSCHRIFT

(11) **EP 3 616 323 B1**
(45) Veröffentlichungstag und Bekanntmachung des Hinweises auf die Patenterteilung: **18.02.2026**
(21) Anmeldenummer: 18718153.2
(22) Anmeldetag: 17.04.2018
(51) Int. Cl.: H04B 1/08, B60R 11/02, H05K 7/20

(54) **ABGESETZTES TUNERMODUL MIT VERBESSERTEN WÄRMEEIGENSCHAFTEN**
SETTLED TUNING MODUL WITH IMPROVED THERMAL CHARACTERISTICS
MODULE DEPOSÉ DE SYNTONISATION AVEC PROPRIETÉS THÉRMIQUES AMÉLIORÉES

(30) Priorität: 24.04.2017 DE 102017108638
(43) Veröffentlichungstag der Anmeldung: 04.03.2020
(73) Patentinhaber: HIRSCHMANN CAR COMMUNICATION GMBH, 72654 Neckartenzlingen (DE)
(72) Erfinder: ADAM, Thomas, 72574 Bad Urach (DE); SAUTTER, Wolfgang, 72770 Reutlingen (DE); DAUM, Uwe, 70794 Filderstadt (DE); AMLER, Ralf, 72663 Großbettlingen (DE); SILVA, David, 72622 Nürtingen (DE)
(74) Vertreter: Patentanwaltskanzlei WILHELM & BECK
(86) Internationale Anmeldenummer: PCT/EP2018/059736
(87) Internationale Veröffentlichungsnummer: WO 2018/197260

(56) Entgegenhaltungen:
- EP-A2- 0 806 851
- EP-A2- 0 806 851
- EP-A2- 0 806 851
- EP-A2- 2 802 006
- EP-A2- 2 802 006
- US-A1- 2012 307 453
- US-A1- 2012 307 453
- US-A1- 2012 307 453

## Beschreibung

Die Erfindung betrifft ein Radio Tuner Modul für den mobilen Empfang von hochfrequenten Signalen in Fahrzeugen, eine Kommunikationsanordnung mit einem solchen Tuner sowie ein Fahrzeug mit einer solchen Kommunikationsanordnung gemäß den Merkmalen des Oberbegriffes der jeweiligen unabhängigen Patentansprüche.

Die US 2012/307453 A1 beschreibt ein elektronisches Gerät mit einem als Wärmerohr ausgebildeten Gehäusedeckel.

Die EP 2 802 006 A2 beschreibt ein in einem Fahrzeug montierbares Modul zur drahtlosen Datenkommunikation. Ein in einem Gehäuse angeordnetes wärmeerzeugendes Element ist über ein Wärmeleitpad an einen metallischen Teil des Gehäusedeckels angekoppelt.

Es sind Tuner für den mobilen Empfang von hochfrequenten Signalen in Fahrzeugen bekannt, die zum bestimmungsgemäßen Anordnen und Befestigen an ihrem Einbauort ein Gehäuse aufweisen, wobei das Gehäuse gebildet ist von einem ersten Gehäuseteil und zumindest einem weiteren Gehäuseteil, wobei in dem Gehäuse zumindest eine Leiterplatte angeordnet ist, wobei auf der zumindest einen Leiterplatte zumindest ein wärmekritisches Elektronikbauteil zur Realisierung zumindest einer Teilfunktion des Tuners angeordnet ist. Selbstverständlich sind weitere Bauteile des Tuners wie weitere Elektronikbauteile, Steckverbindungen, mechanische Bauteile und dergleichen vorhanden, die auch wärmekritisch sein können, jedoch nicht wärmekritisch sein müssen. An dem bestimmungsgemäßen Einbauort des Tuners innerhalb eines Fahrzeuges herrschen je nach äußeren Bedingungen, insbesondere durch Sonneneinstrahlung oder Wärmestau, sehr hohe Temperaturen, die entweder zu einer Beeinträchtigung der Funktion des Tuners oder sogar zu einem vollständigen Ausfall führen können. Die Beeinträchtigungen beziehungsweise der Ausfall kann gewollt durch Abschalten von Teilfunktionen oder des gesamten Tuners erfolgen, wobei jedoch auch Beschädigungen und Ausfälle infolge der hohen Temperaturen auftreten können, die im schlimmsten Fall einen Austausch des gesamten Tuners erforderlich machen.

Die Erfindung betrifft mit anderen Worten ein abgesetztes Radio Tuner Modul, im weiteren Verlauf auch als Remote Tuner Modul oder nur mit Tuner bezeichnet, welches in unmittelbarer Nähe zu einer oder mehreren Antennen angebracht ist. Die Antennen befinden sich dabei in aller Regel in/auf der "Außenhaut" eines Fahrzeugs (z.B. Scheibenantennen), außerhalb des Fahrzeugs (z.B. Spiegel, Dachantennen, Smart Antennen) oder unmittelbar unterhalb der Karosserie (z.B. Stoßfänger oder sogenannte Smart Bars).

Den meisten Bauräumen gemeinsam sind mehrere technische Herausforderungen. Dies ist einmal der extrem kleine zur Verfügung stehende Bauraum, die Bearbeitung von digitalen und analogen HF-Signalen in unmittelbarer Nähe zu diversen Empfangsantennen (EMV), als auch die durch Sonneneinstrahlung und Eigenerwärmung der Elektronikbauteile (IC's) verursachte Wärme im Inneren des Gehäuses des Tuners.

In den exemplarisch genannten Bauräumen insbesondere unmittelbar unter dem Dach als auch im Bereich der Scheibenantennen herrschen je nach Region, Jahreszeit und Sonneneinstrahlung extreme Temperaturen im Bereich von bis zu ca. 105°C. Diesen Temperaturen muss ein Tuner im Betrieb oder zumindest im eingeschränkten Betrieb standhalten können. Die heute dazu zur Verfügung stehenden Tuner-Bausteine aus dem automotiven Bereich sind weitestgehend im Bereich von -40°C bis +85°C spezifiziert und damit in nachteiliger Weise zunächst einmal nicht für diese Bauräume ausgelegt. Der jedoch viel wichtigere und zu beachtende technische Parameter für die IC's hinsichtlich maximal möglicher Umgebungstemperatur ist die Junction Temperatur. Diese liegt typisch bei 125°C und darf nicht überschritten werden. Die Aufgabe eines Tuner-Konzeptes besteht also darin, mit den genannten Rahmenbedingungen zurecht zu kommen.

Aus der EP 0 806 851 A2 ist ein Rundfunkempfangssystem für ein Fahrzeug mit Ein-/Ausgabeeinheiten bekannt, welches prinzipiell mehrere Empfangseinheiten besitzt, die von der Ein-/Ausgabeeinheit abgesetzt ausgebildet sind. Die Empfangseinheiten sind untereinander und mit der Ein-/Ausgabeeinheit über eine Verbindungsleitung für digitale Signale verbunden. Die Empfangseinheiten und die zugeordneten Antennen sind in enger räumlicher Nähe zueinander angeordnet. Weiterhin wird in der Anmeldung beschrieben, dass das über die Antenne empfangene Signal über die Antennenleitung dem Rundfunkempfänger zugeführte Antennensignal im Tunerteil demoduliert und nach der Qualität bewertet, in der Signalaufbereitungseinheit adaptiert und verstärkt an die Ausgänge geleitet wird. Auch beschrieben wird, dass das Rundfunkempfangssystem als dezentralisiertes System ausgebildet ist, das eine Ein-/Ausgabeeinheit und mehrere davon abgesetzte Empfangseinheiten besitzt. Jede der Empfangseinheiten zeigt eine Steuereinheit, ein Tunerteil und eine Signalaufbereitungseinheit mit digitaler Schnittstelle sowie zumindest eine ihr zugeordnete Antenne. In diesem Stand der Technik wird erklärt, dass durch die dezentrale Anordnung der Empfangseinheiten es gelingt, die Funktion an die geeignete Position zu bringen. Weiterhin wird beschrieben, dass im Bereich der Konsole des Fahrzeuges aufgrund der erforderlichen Bedienbarkeit für den Benutzer für die verschiedensten Geräte stets ein enormer Raummangel herrscht. Die Anforderungen hinsichtlich Temperatur und EMV sind für den Remote Tuner, der nun direkt an der Antenne in den eingangs genannten Bauräumen angebracht ist, um ein Vielfaches höher und schwieriger in den Griff zu bekommen.

Der Erfindung liegt daher die Aufgabe zugrunde, einen Tuner, eine Kommunikationsordnung mit einem solchen Tuner sowie ein Fahrzeug mit einer solchen Kommunikationsanordnung hinsichtlich des Wärmemanagements des Tuners zu verbessern und Ausfälle zu vermeiden.

Diese Aufgabe ist durch die Merkmale des unabhängigen Patentanspruchs gelöst.

Hinsichtlich des Tuners ist erfindungsgemäß vorgesehen, dass zumindest ein Bereich eines Gehäuseteiles aus einem wärmeleitfähigen Material mit hoher Wärmeleitfähigkeit besteht und das zumindest eine wärmekritische Elektronikbauteil wärmeübertragend mit diesem Bereich verbunden ist. Damit wird es ermöglicht, dass das wärmekritische Elektronikbauteil, welches entweder selber während des Betriebes hohe Temperaturen erzeugt und /oder aufgrund der Umgebungstemperatur wärmekritischen Temperaturen ausgesetzt ist, gezielt über eine Wärmekoppelung mit dem zumindest einen wärmeleitfähigen Bereich des zumindest einen Gehäuseteiles gekoppelt ist, um die kritische Temperatur zu senken, indem Wärme von dem wärmekritischen Bauteil über den zumindest einen Bereich des Gehäuseteiles nach außerhalb des Gehäuses des Tuners abgeführt wird. Dies kann noch dadurch gesteigert werden, dass nicht nur ein Teilbereich eines Gehäuseteiles des Gehäuses aus einem wärmeleitfähigen Material besteht, sondern dass auch das gesamte Gehäuseteil oder auch die zumindest beiden Gehäuseteile aus einem wärmeleitfähigen Material (gleiches oder unterschiedliches Material) bestehen. Als wärmeleitfähiges Material mit hoher Wärmeleitfähigkeit kommen beispielsweise Stahlwerkstoffe, Leichtbauwerkstoffe wie Aluminium, aber auch Kunststoffe mit hoher Wärmeleitfähigkeit in Betracht. Außerdem kann die Wärmeabfuhr noch dadurch gesteigert werden, dass die Wärme von dem wärmekritischen Bauteil nicht nur über das Gehäuse abgeführt wird, sondern von dem Gehäuse auch an weitere Elemente, wie zum Beispiel Teile der Fahrzeugkarosserie, angebunden sind und abgegeben werden. Darüber hinaus sind noch weitere wärmeübertragende Maßnahmen denkbar, die im Folgenden im Zusammenhang mit den weiteren Unteransprüchen beschrieben werden.

Nach der Erfindung wird in vorteilhafter Weise die notwendige Verlässlichkeit, Belastbarkeit und Performance des Tuners und des Rundfunksystems (Kommunikationssystems), in dem der Tuner eingesetzt wird, durch eine Komposition aus Funktionalität bzw. temperaturabhängig geregelter Funktionalität, dem mechanischen Aufbau und unter Einsatz von entsprechenden EMV-Maßnahmen für den angestrebten Bauraum erreicht.

Ein besonders einfacher Aufbau eines Gehäuses eines Tuners ist dadurch realisiert, dass genau zwei Gehäuseteile das Gehäuse bilden und beide Gehäuseteile aus einem wärmeleitfähigen Material mit hoher Wärmeleitfähigkeit bestehen und wiederum das zumindest ein wärmekritisches Elektronikbauteil wärmeübertragend mit zumindest einem der beiden Gehäuseteile verbunden ist. Die beiden Gehäuseteile können gleichartig oder unterschiedlich voneinander gestaltet werden, um die zumindest eine Leiterplatte, vorzugsweise genau eine Leiterplatte, aufzunehmen. Sind beide Gehäuse Gleichteile, lässt sich ein besonders einfacher Aufbau und eine einfache Montage realisieren, um insbesondere eine Serienproduktion von solchen Tunern kostengünstig zu gestalten.

In Weiterbildung der Erfindung ist eine Außenfläche des Gehäuses, insbesondere eines oder beider Gehäuseteile, die in einen freien Raum an einem Einbauort des Tuners weist, zumindest teilweise mit einer Beschichtung aus einem wärmeabstrahlenden Material versehen. Dadurch kann die Wärme des wärmekritischen Bauteiles über das Gehäuse bzw. eines der Gehäuseteile, welches direkt oder indirekt mit dem Elektronikbauteil gekoppelt ist, nach außen abgeführt, das heißt abgestrahlt werden. In Weiterbildung der Erfindung ist die Beschichtung von einer Lackierung hoher Immissionsfähigkeit oder einer Eloxierung gebildet. Nach der Herstellung des Gehäuses, insbesondere der Gehäuseteile, kann der entsprechende Bereich, zum Beispiel eine großflächige Unterseite oder Oberseite, mit einer Lackierung oder einer Eloxierung (wenn das Gehäuse aus einem Leichtbauwerkstoff besteht) versehen werden, um die Wärmeabgabe in einen freien Raum zu realisieren. Nicht nur in dem Falle der Beschichtung, sondern allgemein hat die Bildung zumindest eines Gehäuseteiles aus einem Werkstoff mit hoher Leitfähigkeit den positiven Effekt, dass die dorthin von dem Elektronikbauteil abgegebene und übertragene Wärme gespreizt wird, um großflächig abgegeben werden zu können. lm Falle der Beschichtung mit einer Lackierung kommt beispielsweise eine weiße Lackierung in Betracht, da diese eine hohe Emissionsfähigkeit aufweist.

Die Leiterplatte ist thermisch an das Gehäuse angekoppelt. Dadurch wird die Wärme, die in dem Inneren des Gehäuses entsteht, insbesondere durch Wärmestau bzw. aufgrund der Wärmeentwicklung während des Betriebes des Elektronikbauteiles, von der Leiterplatte aufgenommen und an das Gehäuse übertragen. Von dort aus wird die Wärme wiederum großflächig über das Gehäuseteil aus dem Material mit hoher Wärmeleitfähigkeit gespreizt und nach außen abgegeben bzw. von dort aus auf geeignete Art und Weise weiter übertragen, um somit den Innenbereich des Gehäuses zu kühlen.

Zur thermischen Ankopplung der Leiterplatte an das Gehäuse ist vorgesehen, dass das Gehäuse zumindest ein in Richtung der Leiterplatte abstehendes Wärmeelement, vorzugsweise mehrere Wärmeleitelemente, aufweist, wobei dieses zumindest eine Wärmeleitelement stoff- und / oder formschlüssig mit der Leiterplatte verbunden ist. Dieses Wärmeleitelement kann beispielsweise ein abstehender Vorsprung, ein Befestigungspinn oder dergleichen sein. Wichtig ist, dass die Leiterplatte wärmeübertragend mit dem Gehäuse bzw. einem der Gehäuseteile stoff- und / oder formschlüssig verbunden ist, damit eine Wärmeübertragung von der Leiterplatte und somit von dem zumindest einen Elektronikbauteil über das Gehäuse nach außen und die dortige Wärmeabgabe erfolgen kann.

Die Wärmeankopplung der Leiterplatte an das Gehäuse erfolgt dadurch, dass ein Randbereich der Leiterplatte stoff- und / oder formschlüssig mit dem Gehäuse verbunden ist. Dadurch wird weiterhin die wärmeübertragende Ankopplung der Leiterplatte an das Gehäuse verbessert. Es kommt zur Wärmeankopplung ein Teil des Randbereiches, vorzugsweise aber auch der gesamte umlaufende Randbereich der Leiterplatte in Betracht.

In Weiterbildung der Erfindung weist das Gehäuse zumindest eine in das Innere des Gehäuses weisende flächige Erhebung auf, wobei sich die Erhebung in dem Bereich befindet, in dem sich auch das zumindest eine wärmekritische Elektronikbauteil befindet. Dadurch kann eine zielgerichtete Ankopplung des Gehäuses, genauer des Gehäuseteiles, an das Elektronikbauteil erfolgen, um von diesem Wärme aufzunehmen, über die flächige Erhebung zu spreizen und weiter über die Außenseite des Gehäuseteiles abzugeben. Während das vorstehend beschriebene Wärmeelement, beispielsweise ausgeführt als Befestigungspinn, auch an anderer Stelle vorhanden sein kann, um die Leiterplatte mechanisch und wärmeübertragend an das Gehäuseteil zu koppeln, befindet sich die flächige Erhebung genau in dem Bereich, in dem das wärmekritische Elektronikbauteil auf der Leiterplatte angeordnet ist. In idealer Weise ist die Fläche dieser flächigen Erhebung genau so groß wie die Fläche des Elektronikbauteiles, kann aber auch kleiner oder größer als diese sein.

In Weiterbildung der Erfindung ist das zumindest eine wärmekritische Elektronikbauteil über ein flexibles Wärmeleitmaterial mit dem Gehäuse und/ oder dem separaten Wärmeleitelement und /oder der flächigen Erhebung des Gehäuses verbunden. Durch das flexible Wärmeleitmaterial, zum Beispiel ein Wärmeleitpad, ein Wärmeleitgel, ein Wärmeleitkleber oder dergleichen erfolgt eine deutlich verbesserte thermische Anbindung des wärmekritischen Elektronikbauteiles an das Gehäuse, das separate Wärmeleitelement und / oder der flächigen Erhebung des Gehäuses, sodass dadurch die Abfuhr von Wärme aus dem Elektronikbauteil heraus an seine Umgebung deutlich gesteigert werden kann.

In Weiterbildung der Erfindung ist ein separates Wärmeleitelement aus einem Material mit hoher Wärmeleitfähigkeit innerhalb des Gehäuses angeordnet, wobei das Wärmeleitelement wärmeleitend mit dem Gehäuse und dem zumindest einen wärmekritischen Elektronikbauteil verbunden ist. In diesem Fall wird nicht oder nicht nur die Leiterplatte zur Wärmeabfuhr genutzt, sondern es wird das separate zusätzliche Wärmeleitelement eingesetzt, welches zur Wärmeabfuhr von dem Elektronikbauteil in Richtung des Gehäuses, bzw. eines Gehäuseteiles, geeignet und ausgebildet ist. Außerdem bewirkt ein solches separates Wärmeleitelement innerhalb des Gehäuses eine weitere Wärmeaufnahme und Wärmeabfuhr von Wärme aus dem inneren Volumen des Gehäuses nach außen.

In Weiterbildung der Erfindung ist das Gehäuse auf seiner Außenfläche mit einem Wärmeleitelement zur wärmeübertragenden Anbindung an ein Bauteil am Einbauort des Tuners versehen. Während mit den vorstehend beschriebenen Maßnahmen realisiert wurde, dass die Wärme von dem Elektronikbauteil in Richtung der Außenfläche des Gehäuses transportiert und dort gespreizt wurde, kann mittels des zusätzlichen auf der Außenfläche des Gehäuses angebrachten Wärmeleitelementes die Wärme weiterhin von dem Tuner in Richtung eines Bauteiles an dem Einbauort des Tuners abgeführt werden. Durch diese Maßnahme erfolgt eine weitere Reduzierung der Temperatur im Inneren des Gehäuses des Tuners. Dieses Wärmeleitelement ist bevorzugt flächig gestaltet und wird mit einem Gehäuseteil verbunden, zum Beispiel aufgeklebt. Dadurch ist eine durchgehende Wärmeübertragung gewährleistet, da eine isolierende Luftschicht zwischen dem Wärmeleitelement und dem Gehäuseteil vermieden wird. Die flächige Erstreckung des Wärmeleitelementes ist vorzugsweise der Fläche des Gehäuseteiles angepasst, das heißt, dass es nicht an den Rändern übersteht. Es kann aber kleiner oder größer sein als die flächige Erstreckung des Gehäuseteiles. Ausnehmungen innerhalb des flächigen Wärmeleitelementes sind möglich, zum Beispiel Ausstanzungen. Mit der dem Gehäuseteil abgewandten Fläche wird das Wärmeleitelement an seinem Einbauort angeordnet, zum Beispiel durch eine Flächenpressung zwecks Wärmeübertragung an das Bauteil, an dem es angeordnet wird. Zusätzlich zu der Flächenpressung oder anstelle dieser kommt eine stoffschlüssige Verbindung, wie eine Verklebung, in Betracht. Das flächige Wärmeleitelement weist entweder eine gleichmäßige Dicke auf oder die Dicke ist in ihrem Flächenverlauf der Geometrie des Gehäuseteiles und/oder der Geometrie des Bauteiles am Einbauort angepasst. Dies ist vor allen Dingen dann erforderlich, wenn der Spalt über die Fläche betrachtet zwischen der Oberfläche des Gehäuseteiles und der Oberfläche des Bauteiles am Einbauort nicht gleichmäßig ist. Dadurch können Unebenheiten (zum Beispiel aufgrund von Toleranzen oder vorhandenen Unebenheiten, Krümmungen und dergleichen) ausgeglichen werden, um eine gezielt Wärmespreizung durch das Gehäuseteil in Richtung Bauteiles über das Wärmeleitelement zu erzielen und dadurch die Wärme aus dem Inneren des Gehäuses nicht nur über das Gehäuseteil, sondern zusätzlich über das Bauteil am Einbauort abzuführen. Zu diesem Zweck ist das flächige Wärmeleitelement durchgehend gleich dick oder von unterschiedlicher Dicke, gegebenenfalls auch zwecks Anpassung an den unterschiedlich dicken Spalt elastisch verformbar.

In Weiterbildung der Erfindung weist das Gehäuse zumindest eine abstehende Verschraubungslasche auf. Diese abstehende Verschraubungslasche ist von dem zumindest einen Gehäuseteil des Gehäuses gebildet und wird dazu genutzt, um das Gehäuse des Tuners an seinem bestimmungsgemäßen Einbauort durch eine Verschraubung festzulegen. Gleichzeitig kann mittels dieser Verschraubung auch eine elektrische Masseanbindung realisiert werden. Von weiterer Wichtigkeit ist jedoch, dass über die abstehende Verschraubungslasche auch Wärme von dem Gehäuse, die aus dessen Inneren abgeführt werden soll, nach außen in Richtung des Bauteiles, an dem der Tuner mittels der Verschraubungslasche befestigt wird, zwecks Kühlung weiter übertragen wird.

In Weiterbildung der Erfindung ist die Breite der Verschraubungslasche mindestens doppelt so groß wie der größte Durchmesser einer Schraube, mit der die Verschraubungslasche zwecks Festlegung des Tuners an seinem bestimmungsgemäßen Einbauort zusammenwirkt. Dadurch erfolgt eine weitere Spreizung der übertragenen Wärme, die somit über eine größere Breite bzw. eine größere Fläche an den bestimmungsgemäßen Einbauort abgegeben werden kann.

Weiterhin ist erfindungsgemäß vorgesehen, dass der vorstehend beschriebene Tuner in einem Kommunikationssystem eines Fahrzeuges eingesetzt wird. Der Tuner ist dabei einerseits mit zumindest einer Antenne beliebiger Bauart verbunden und kann über diese zumindest eine Antenne hochfrequente Signale empfangen und/ oder aussenden. insbesondere die mittels der zumindest einen Antenne empfangenen hochfrequenten Signale werden innerhalb des Tuners aufbereitet und über eine Schnittstelle des Tuners zur weiteren Verarbeitung abgegeben. Die Schnittstelle kann beliebiger Art sein, wobei in bevorzugter Weise an dieser Schnittstelle niederfrequente Analogsignale und/oder digitale Signale zur weiteren Verarbeitung durch nachgeschaltete elektronische Einheiten bereitgestellt werden.

Schließlich ist erfindungsgemäß vorgesehen, dass ein Fahrzeug mit einer Kommunikationsanordnung wie vorstehend beschrieben ausgerüstet ist.

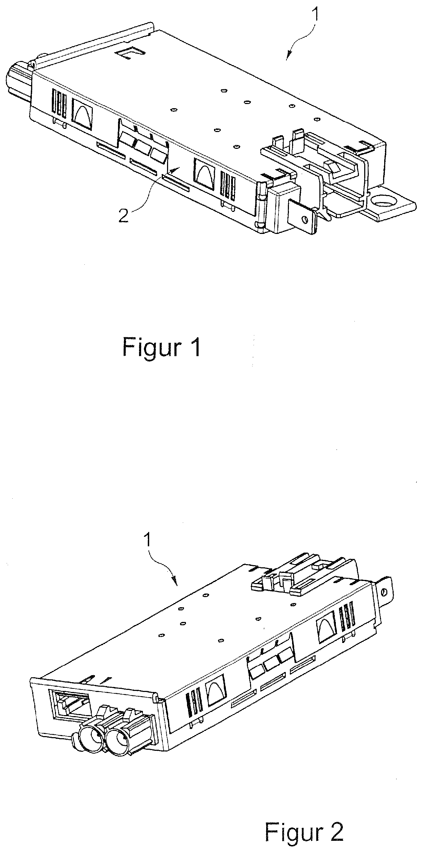

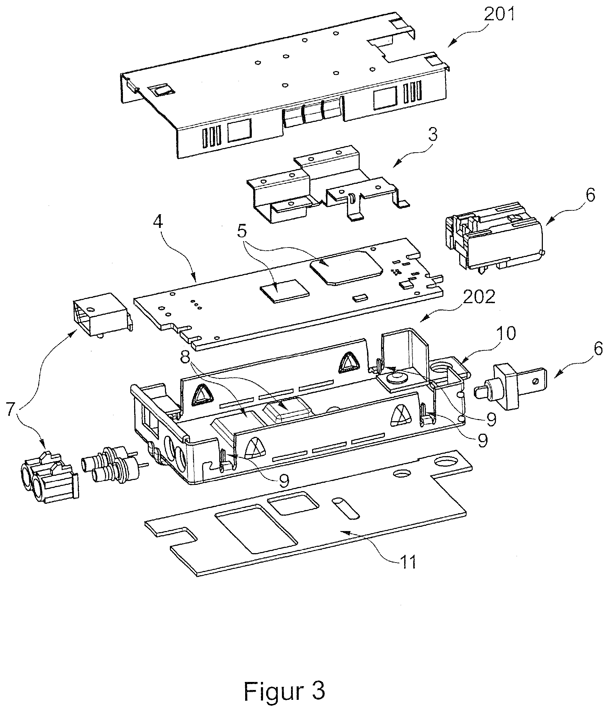

Ein Ausführungsbeispiel eines erfindungsgemäßen Tuners ist im Folgenden erläutert und anhand der Figur beschrieben.

Mit der Bezugsziffer 1 ist, soweit im Einzelnen dargestellt, ein Tuner versehen, der ein Gehäuse 2 aufweist. Das Gehäuse 2 besteht in diesem Fall aus genau zwei Gehäuseteilen, nämlich einem oberen Gehäuseteil 201 und einem unteren Gehäuseteil 202. Beide Gehäuseteile 201, 202 bestehen aus einem Material mit hoher Wärmeleitfähigkeit, wobei diese Gehäuseteile 201, 202 dazu genutzt werden, mittels verschiedener, im Folgenden beschriebener Maßnahmen die Wärme aus dem Inneren des Gehäuses 2 des Tuners 1 zu spreizen und nach außen abzugeben.

Eine Maßnahme ist darin zu sehen, dass ein separates Wärmeleitelement 3 im Inneren des Gehäuses 2 des Tuners 1 eingesetzt wird, welches ein auf einer Leiterplatte 4 angeordnetes Elektronikbauteil 5 kühlen soll. Hierzu ist das Wärmeleitelement 3 wärmekoppelnd mit dem Elektronikbauteil 5 verbunden. Da das Wärmeleitelement 3 selber aus einem wärmeleitfähigen Material, wie zum Beispiel einem Stahlblech, einem Aluminiumblech oder dergleichen, besteht, nimmt es die Wärme des Elektronikbauteiles 5 auf, leitet es weiter zum Beispiel an die Leiterplatte 4 und /oder an eines der Gehäuseteile 201, 202, um das Elektronikbauteil 5 zu kühlen. In dem Ausführungsbeispiel gemäß der Figur ist nicht nur ein einziges Elektronikteil 5 vorhanden, sondern es können auch mehrere Elektronikbauteile 5 mit dem separaten Wärmeleitelement 3 verbunden sein.

Mit 6 ist ein Steckverbinder für die Stromversorgung und die Übertragung von Signalen für den Tuner 1 bezeichnet. Weiterhin ist ein Steckverbinder 7 für einen Antennenanschluss des Tuners 1 vorhanden.

Zur thermischen Anbindung sind flächige Erhebungen 8, die in das Innere des Gehäuses 2, hier abstehend von dem Gehäuseteil 202, vorhanden. Diese flächigen Erhebungen 8 sind vorzugsweise an genau den Stellen vorhanden, an denen sich ein Elektronikbauteil 5 befindet. Es ist aber auch denkbar, nicht ein Elektronikbauteil 5, sondern einen Teilbereich der Leiterplatte 4 über diese nach innen weisenden Flächen 8 an das Gehäuse 2 thermisch anzukoppeln.

Weiterhin sind zur Wärmeabfuhr Wärmeleitelemente 9 vorhanden, die in diesem Fall von dem unteren Gehäuseteil 202 gebildet sind. Diese Wärmeleitelemente 9 sind als in das Innere des Gehäuses 2 weisende Befestigungspins ausgebildet, die mit entsprechenden Öffnungen in der Leiterplatte 4 zusammenwirken. Das bedeutet, dass die Leiterplatte 4 über ihre entsprechenden Öffnungen auf die als Befestigungspins ausgebildeten Wärmeleitelemente 9 aufgesetzt werden kann. Danach erfolgt eine stoff- und/oder formschlüssige Verbindung dieser Wärmeleitelemente 9 mit der Leiterplatte 4. Die stoffschlüssige Verbindung kann beispielsweise durch Verlöten erfolgen. In Bezug auf eine formschlüssige Verbindung kommt zum Beispiel ein Verstemmen, Verpressen oder dergleichen in Betracht.

Zur weiteren Steigerung der Wärmeabfuhr von dem Inneren des Gehäuses 2 nach außen kann daran gedacht werden, dass die innere Kontur der Seitenwände des unteren Gehäuseteiles 2 einigen Randbereichen der Leiterplatte 4, das heißt deren äußerer Kontur, entspricht, sodass Teile der Randbereiche der Leiterplatte 4 wärmekoppelnd an den Innenflanken des unteren Gehäuseteiles 202 zur Anlage kommen.

Die vorstehend beschriebenen Maßnahmen zur wärmeübertragenden Ankopplung von Elementen des Tuners 1 können dadurch unterstützt werden, dass zwischen den einander anliegenden Bereichen ein flexibles wärmeleitfähiges Material, wie zum Beispiel ein Wärmeleitgel, ein Wärmeleitpad, ein wärmeleitfähiger Kleber oder dergleichen dazwischen angeordnet wird.

Zur Befestigung des Gehäuses 2 des Tuners 1 an seinem bestimmungsgemäßen Einbauort ist zumindest eine Verschraubungslasche 10, die nach außen weist, vorgesehen. Diese Verschraubungslasche 10 weist eine Öffnung auf, durch die eine nicht dargestellte Befestigungsschraube geführt wird, die in ein Bauteil an dem Einbauort des Tuners 1, beispielsweise einem Karosserieteil des Fahrzeuges, eingeschraubt werden kann. Über diese Verschraubungslasche 10 und die damit zusammenwirkende Befestigungsschraube erfolgt nicht nur eine dauerhafte Befestigung, sondern es kann auch eine elektrische Masseanbindung erfolgen und vor allen Dingen wird dadurch auch eine weitere Wärmeübertragung, Wärmespreizung und Abgabe von dem Inneren des Gehäuses 2 an das Fahrzeugbauteil bewirkt.

Eine weitere Wärmespreizung, Wärmeübertragung und Wärmeankopplung kann durch ein Wärmeleitelement 11 erfolgen. Dieses Wärmeleitelement 11 ist angeordnet zwischen zumindest einen* Gehäuseteil, hier dem unteren Gehäuseteil 202, und einem Bauteil des Fahrzeuges (hier nicht dargestellt). insbesondere dann, wenn dieses Wärmeleitelement 11, beispielsweise ausgebildet als ein Wärmeleitpad, flächig gestaltet ist, erfolgt eine Spreizung der Wärme und damit eine Ankopplung und Abgabe der Wärme von dem Gehäuse 2 an das Fahrzeugbauteil über einen großflächigen Bereich. Dass in dem Ausführungsbeispiel 11 dargestellte Wärmeleitelement 11 weist zumindest zwei beispielsweise rechteckförmige Ausnehmungen auf, die in dem Bereich angeordnet sind, in dem sich die in das Innere des Gehäuses 2 weisenden Flächen beziehungsweise Erhebungen 8 zur thermischen Anbindung an das Elektronikbauteil 5 befinden. Diese Flächen sind von dem Wärmeleitelement 11 ausgenommen, weil sie nach außen hin mit einer wärmeabstrahlenden Beschichtung, wie zum Beispiel mit einer Farbe hoher Emissionsfähigkeit oder einer Eloxierung, versehen sind. In diesem Fall würde die Überdeckung dieser Flächen 8 mit dem Wärmeleitelement 11 der Wärmeabgabe nach außen zuwiderlaufen.

### Bezugszeichenliste

- 1.: Tuner
- 2.: Gehäuse
- 201.: Oberes Gehäuseteil
- 202.: Unteres Gehäuseteil
- 3.: Wärmeleitelement
- 4.: Leiterplatte
- 5.: Elektronikbauteil
- 6.: Steckverbinder Stromversorgung und digitale Signale
- 7.: Steckverbinder Antennenanschlüsse
- 8.: Flächen zur thermischen Anbindung
- 9.: Wärmeleitelement
- 10.: Verschraubungslasche
- 11.: Wärmeleitelement

## Patentansprüche

1. Radio Tuner Modul (1) für den mobilen Empfang von hochfrequenten Signalen in Fahrzeugen, aufweisend ein Gehäuse (2), gebildet von einem ersten Gehäuseteil (201) und zumindest einem weiteren Gehäuseteil (202), und eine in dem Gehäuse (2) angeordnete Leiterplatte (4), wobei auf der Leiterplatte (4) zumindest ein wärmekritisches Elektronikbauteil (5) zur Realisierung zumindest einer Teilfunktion des Radio Tuner Moduls (1) angeordnet ist,
wobei zumindest ein Bereich eines Gehäuseteiles (201, 202) aus einem wärmeleitfähigen Material mit hoher Wärmeleitfähigkeit besteht und das zumindest eine wärmekritische Elektronikbauteil (5) wärmeübertragend mit diesem Bereich verbunden ist, wobei die Leiterplatte (4) thermisch an das Gehäuse (2) angekoppelt ist, wobei ein Randbereich der Leiterplatte (4) stoff- und/oder formschlüssig mit dem Gehäuse (2) verbunden ist, wobei das Gehäuse (2) zumindest ein in Richtung der Leiterplatte (4) abstehendes Wärmeleitelement (9) aufweist, wobei dieses zumindest eine Wärmeleitelement (9) stoff- und/oder formschlüssig mit der Leiterplatte (4) verbunden ist.

2. Radio Tuner Modul (1) nach Anspruch 1, **dadurch gekennzeichnet, dass** zwei Gehäuseteile (201, 202) das Gehäuse (2) bilden und beide Gehäuseteile (201, 202) aus einem wärmeleitfähigen Material mit hoher Wärmeleitfähigkeit bestehen und das zumindest eine wärmekritische Elektronikbauteil (5) wärmeübertragend mit zumindest einem der beiden Gehäuseteile (201, 202) verbunden ist.

3. Radio Tuner Modul (1) nach Anspruch 1 oder 2, **dadurch gekennzeichnet, dass** eine Außenfläche des Gehäuses (2), die in einen freien Raum an einem Einbauort des Radio Tuner Moduls (1) weist, zumindest teilweise mit einer Beschichtung aus einem wärmeabstrahlendem Material versehen ist.

4. Radio Tuner Modul (1) nach Anspruch 3, **dadurch gekennzeichnet, dass** die Beschichtung von einer Lackierung hoher Emissionsfähigkeit, insbesondere eine weiße Lackierung, oder Eloxierung gebildet ist.

5. Radio Tuner Modul (1) nach einem der vorhergehenden Ansprüche, **dadurch gekennzeichnet, dass** ein separates Wärmeleitelement (3) aus einem Material mit hoher Wärmeleitfähigkeit innerhalb des Gehäuses (2) angeordnet ist, wobei das Wärmeleitelement (3) wärmeleitend mit dem Gehäuse (2) und dem zumindest einen wärmekritischen Elektronikbauteil (5) verbunden ist.

6. Radio Tuner Modul (1) nach Anspruch 5, **dadurch gekennzeichnet, dass** das zumindest eine wärmekritische Elektronikbauteil (5) über ein flexibles Wärmeleitmaterial mit dem separaten Wärmeleitelement (3) verbunden ist.

7. Radio Tuner Modul (1) nach einem der vorhergehenden Ansprüche, **dadurch gekennzeichnet, dass** das Gehäuse (2) zumindest eine in das Innere des Gehäuses (2) weisende flächige Erhebung (8) aufweist, wobei sich die Erhebung (8) in dem Bereich befindet, in dem sich auch das zumindest eine wärmekritische Elektronikbauteil (5) befindet.

8. Radio Tuner Modul (1) nach Anspruch 7, **dadurch gekennzeichnet, dass** das zumindest eine wärmekritische Elektronikbauteil (5) über ein flexibles Wärmeleitmaterial mit der flächigen Erhebung (8) des Gehäuses (2) verbunden ist.

9. Radio Tuner Modul (1) nach einem der vorhergehenden Ansprüche, **dadurch gekennzeichnet, dass** das zumindest eine wärmekritische Elektronikbauteil (5) über ein flexibles Wärmeleitmaterial mit dem Gehäuse (2) verbunden ist.

10. Radio Tuner Modul (1) nach einem der vorhergehenden Ansprüche, **dadurch gekennzeichnet, dass** das Gehäuse (2) auf seiner Außenfläche mit einem Wärmeleitelement (11) zur wärmeübertragenden Anbindung an ein Bauteil am Einbauort versehen ist.

11. Radio Tuner Modul (1) nach einem der vorhergehenden Ansprüche, **dadurch gekennzeichnet, dass** das Gehäuse (2) zumindest eine abstehende Verschraubungslasche (10) aufweist.

12. Radio Tuner Modul (1) nach Anspruch 11, **dadurch gekennzeichnet, dass** die Breite der Verschraubungslasche (10) mindestens doppelt so groß ist wie der größte Durchmesser einer Schraube, mit der die Verschraubungslasche (10) zwecks Festlegung des Radio Tuner Moduls (1) an seinem bestimmungsgemäßen Einbauort zusammenwirkt.

13. Kommunikationssystem eines Fahrzeuges, aufweisend zumindest eine Antenne zum Empfangen hochfrequenter Signale und ein Radio Tuner Modul (1) nach einem der vorhergehenden Ansprüche, wobei das Radio Tuner Modul (1) an der zumindest einen Antenne angeschlossen und benachbart zu der zumindest einen Antenne angeordnet ist.

14. Fahrzeug mit einem Kommunikationssystem gemäß Anspruch 13.

## Claims

1. Radio tuner module (1) for mobile reception of radio-frequency signals in vehicles, comprising a housing (2), formed by a first housing part (201) and at least one further housing part (202), and a printed circuit board (4) that is arranged in the housing (2), wherein at least one heat-critical electronic component (5) for performing at least one partial function of the radio tuner module (1) is arranged on the printed circuit board (4),
wherein at least one region of a housing part (201, 202) consists of a thermally conductive material with high thermal conductivity and the at least one heat-critical electronic component (5) is connected to this region so as to transfer heat, wherein the printed circuit board (4) is thermally coupled to the housing (2), an edge region of the printed circuit board (4) being connected to the housing (2) in an integral and/or form-fitting manner, wherein the housing (2) comprises at least one heat-conducting element (9) that protrudes in the direction of the printed circuit board (4), said at least one heat-conducting element (9) being connected to the printed circuit board (4) in an integral and/or form-fitting manner.

2. Radio tuner module (1) according to Claim 1, **characterized in that** two housing parts (201, 202) form the housing (2) and both housing parts (201, 202) consist of a thermally conductive material with high thermal conductivity and the at least one heat-critical electronic component (5) is connected to at least one of the two housing parts (201, 202) so as to transfer heat.

3. Radio tuner module (1) according to Claim 1 or 2, **characterized in that** an outer face of the housing (2) that points into an empty space at an installation location of the radio tuner module (1) is at least partially provided with a coating made of a heat-emitting material.

4. Radio tuner module (1) according to Claim 3, **characterized in that** the coating is formed by a finish of high emissivity, in particular a white finish, or anodization.

5. Radio tuner module (1) according to one of the preceding claims, **characterized in that** a separate heat-conducting element (3) made of a material with high thermal conductivity is arranged inside the housing (2), the heat-conducting element (3) being thermally conductively connected to the housing (2) and the at least one heat-critical electronic component (5).

6. Radio tuner module (1) according to Claim 5, **characterized in that** the at least one heat-critical electronic component (5) is connected to the separate heat-conducting element (3) via a flexible heat-conducting material.

7. Radio tuner module (1) according to one of the preceding claims, **characterized in that** the housing (2) comprises at least one flat elevation (8) that points into the interior of the housing (2), the elevation (8) being located in the region in which the at least one heat-critical electronic component (5) is also located.

8. Radio tuner module (1) according to Claim 7, **characterized in that** the at least one heat-critical electronic component (5) is connected to the flat elevation (8) of the housing (2) via a flexible heat-conducting material.

9. Radio tuner module (1) according to one of the preceding claims, **characterized in that** the at least one heat-critical electronic component (5) is connected to the housing (2) via a flexible heat-conducting material.

10. Radio tuner module (1) according to one of the preceding claims, **characterized in that** the outer face of the housing (2) is provided with a heat-conducting element (11) for heat-transferring connection to a component at the installation location.

11. Radio tuner module (1) according to one of the preceding claims, **characterized in that** the housing (2) comprises at least one protruding screw connection tab (10).

12. Radio tuner module (1) according to Claim 11, **characterized in that** the width of the screw connection tab (10) is at least twice as large as the largest diameter of a screw with which the screw connection tab (10) interacts to fix the radio tuner module (1) at its intended installation location.

13. Communication system of a vehicle, comprising at least one antenna for receiving radio-frequency signals and a radio tuner module (1) according to one of the preceding claims, the radio tuner module (1) being connected to the at least one antenna and arranged adjacent to the at least one antenna.

14. Vehicle having a communication system according to Claim 13.

## Revendications

1. Module syntoniseur radio (1) pour la réception mobile de signaux à haute fréquence dans des véhicules, comportant un boîtier (2) formé par une première partie de boîtier (201) et au moins une autre partie de boîtier (202), et une carte de circuits imprimés (4) disposée dans le boîtier (2), au moins un composant électronique thermiquement critique (5) servant à réaliser au moins une fonction partielle du module syntoniseur radio (1) étant disposé sur la carte de circuits imprimés (4),
au moins une zone d'une partie de boîtier (201, 202) étant constituée d'un matériau thermoconducteur à conductivité thermique élevée et ledit au moins un composant électronique thermiquement critique (5) étant relié par transmission de chaleur à ladite zone, la carte de circuits imprimés (4) étant couplée thermiquement au boîtier (2), une zone marginale de la carte de circuits imprimés (4) étant reliée par complémentarité de matière et/ou de forme au boîtier (2), le boîtier (2) comportant au moins un élément thermoconducteur (9) faisant saillie en direction de la carte de circuits imprimés (4), et ledit au moins un élément thermoconducteur (9) étant relié par complémentarité de matière et/ou de forme à la carte de circuits imprimés (4).

2. Module syntoniseur radio (1) selon la revendication 1, **caractérisé en ce que** deux parties de boîtier (201, 202) forment le boîtier (2) et les deux parties de boîtier (201, 202) sont constituées d'un matériau thermoconducteur à conductivité thermique élevée, et ledit au moins un composant électronique thermiquement critique (5) est relié par transmission de chaleur à au moins l'une des deux parties de boîtier (201, 202).

3. Module syntoniseur radio (1) selon la revendication 1 ou 2, **caractérisé en ce qu'**une surface extérieure du boîtier (2), qui est tournée vers un espace libre à un emplacement de montage du module syntoniseur radio (1), est pourvue au moins partiellement d'un revêtement constitué d'un matériau émettant de la chaleur.

4. Module syntoniseur radio (1) selon la revendication 3, **caractérisé en ce que** le revêtement est formé par un laquage à haute émissivité, en particulier un revêtement blanc, ou par anodisation.

5. Module syntoniseur radio (1) selon l'une quelconque des revendications précédentes, **caractérisé en ce qu'**un élément thermoconducteur séparé (3) constitué d'un matériau à conductivité thermique élevée est disposé à l'intérieur du boîtier (2), l'élément thermoconducteur (3) étant relié par transmission de chaleur au boîtier (2) et à au moins un composant électronique thermiquement critique (5).

6. Module syntoniseur radio (1) selon la revendication 5, **caractérisé en ce que** ledit au moins un composant électronique thermiquement critique (5) est relié à l'élément thermoconducteur séparé (3) par l'intermédiaire d'un matériau thermoconducteur flexible.

7. Module syntoniseur radio (1) selon l'une quelconque des revendications précédentes, **caractérisé en ce que** le boîtier (2) présente au moins une protubérance (8) plane dirigée vers l'intérieur du boîtier (2), la protubérance (8) se trouvant dans la zone dans laquelle se trouve également ledit au moins un composant électronique thermiquement critique (5).

8. Module syntoniseur radio (1) selon la revendication 7, **caractérisé en ce que** ledit au moins un composant électronique thermiquement critique (5) est relié à la protubérance (8) plane du boîtier (2) par l'intermédiaire d'un matériau thermoconducteur flexible.

9. Module syntoniseur radio (1) selon l'une quelconque des revendications précédentes, **caractérisé en ce que** ledit au moins un composant électronique thermiquement critique (5) est relié au boîtier (2) par l'intermédiaire d'un matériau thermoconducteur flexible.

10. Module syntoniseur radio (1) selon l'une quelconque des revendications précédentes, **caractérisé en ce que** le boîtier (2) est pourvu sur sa surface extérieure d'un élément thermoconducteur (11) pour la liaison par transmission de chaleur à un composant à l'emplacement de montage.

11. Module syntoniseur radio (1) selon l'une quelconque des revendications précédentes, **caractérisé en ce que** le boîtier (2) comporte au moins une patte de vissage (10) saillante.

12. Module syntoniseur radio (1) selon la revendication 11, **caractérisé en ce que** la largeur de la patte de vissage (10) est au moins deux fois supérieure au plus grand diamètre d'une vis avec laquelle la patte de vissage (10) coopère pour fixer le module syntoniseur radio (1) à son emplacement de montage prévu.

13. Système de communication d'un véhicule, comportant au moins une antenne pour recevoir des signaux à haute fréquence et un module syntoniseur radio (1) selon l'une quelconque des revendications précédentes, le module syntoniseur radio (1) étant raccordé à ladite au moins une antenne et étant disposé de manière adjacente à ladite au moins une antenne.

14. Véhicule comprenant un système de communication selon la revendication 13.
